# FASCICULE DE BREVET EUROPEEN

(11) **EP 2 097 208 B1**
(45) Date de publication et mention de la délivrance du brevet: **26.09.2012**
(21) Numéro de dépôt: 07858627.8
(22) Date de dépôt: 19.10.2007
(51) Int. Cl.: B23K 26/06, B23K 26/00, C23C 14/06, F01L 1/047, F01L 1/16, F16C 33/10

(54) **PIECE DE FROTTEMENT EN MILIEU LUBRIFIE TRAVAILLANT A DES PRESSIONS DE CONTACT SUPERIEURES A 200 MPA**
BEI KONTAKTDRUCK VON ÜBER 200 MPA ARBEITENDES REIBUNGSTEIL IN EINER GESCHMIERTEN UMGEBUNG
FRICTION PIECE IN A LUBRICATED MEDIUM, WORKING AT CONTACT PRESSURES HIGHER THAN 200 MPA

(30) Priorité: 20.10.2006 FR 0654414
(43) Date de publication de la demande: 09.09.2009
(73) Titulaire: H.E.F., 42160 Andrézieux-Bouthéon (FR); Université Jean-Monnet, 42000 Saint Etienne Cedex 2 (FR); Centre National de la Recherche Scientifique, 75794 Paris (FR); Ecole Centrale de Lyon, 69134 Ecully (FR)
(72) Inventeur: MAURIN-PERRIER, Philippe, 42680 Saint Marcellin En Forez (FR); LEDRAPPIER, Florent, 42100 Saint Etienne (FR); MOURIER, Louis, 42560 Chenereilles (FR); DONNET, Christophe, 42100 Saint Etienne (FR); AUDOUARD, Eric, 43130 Solignac-Sous-Roches (FR); MAZUYER, Denis, 69130 Ecully (FR)
(74) Mandataire: Thivillier, Patrick
(86) Numéro de dépôt international: PCT/FR2007/052204
(87) Numéro de publication internationale: WO 2008/047062

(56) Documents cités:
- JP-A- 2001 165 167
- JP-A- 2004 360 011
- US-A- 4 573 690
- US-A- 4 620 803
- US-A1- 2002 104 506
- US-A1- 2005 175 837
- US-A1- 2005 217 415
- US-B2- 6 886 521

## Description

L'invention concerne le domaine technique de la tribologie en milieu lubrifié et, en particulier, une pièce de frottement en milieu lubrifiant conformément au préambule de la revendication 1 (voir, par exemple, US 2005/217 415).

Plus particulièrement, l'invention concerne les revêtements et les traitements de surface destinés à réduire l'usure et à minimiser la transmission des efforts tangentiels.

De nombreuses solutions techniques ont été proposées pour améliorer les performances tribologiques des pièces mécaniques. On distingue essentiellement les traitements traditionnels de durcissement superficiel et les dépôts de couches minces et dures obtenues par différents procédés tels que le procédé PVD (Physical Vapour Deposition) ou le procédé PACVD (Plasma Assisted Chemical Vapour Deposition).

Parmi les dépôts de couches minces et dures, on peut citer les dépôts de nitrures de métaux de transition (TiN, CrN, TiAIN, ...), les revêtements de carbone amorphe (DLC)... Pour des raisons techniques, mais aussi mécaniques, il ressort que ces dépôts de revêtement de surface n'excèdent généralement pas 5 µm. Au-delà de cette épaisseur, peuvent apparaître des risques de fragilisation du dépôt et d'écaillage. Il est également important d'obtenir une parfaite adhérence et une tenue dans le temps de la couche mince. Ainsi, l'homme du métier revendique des états de surface très peu accidentées avec une rugosité (Ra) de l'ordre de 0,04 µm.

Il ressort donc de l'état de la technique que les performances tribologiques des traitements de surfaces et des dépôts sous vide, ne sont assurées qu'à condition d'avoir des surfaces de faible rugosité.

On peut citer par exemple l'enseignement du brevet US 6,886,521 qui pose une valeur maximale du paramètre de rugosité de surface (Rz) en fonction de la dureté du dépôt de DLC et de l'épaisseur de celui-ci.

Dans le domaine de la tribologie, de nombreuses études ont été effectuées sur l'influence de la topographie des surfaces en contact sur l'établissement d'un régime de lubrification hydrodynamique, C'est ainsi que l'on a proposé de réaliser une texturation de paliers ou de butées afin de favoriser la séparation de surfaces par une portance du lubrifiant améliorée. On peut citer, par exemple, l'enseignement des documents US 5,952,080 et WO2004/063533.

**Le document** US 2005/217415 **divulgue une texturation faisant office de réservoir de lubrifiant en régime hydrodynamique avec, pour objectif, de pomper le lubrifiant afin de former un film.**

Toutefois, le dimensionnement de la topographie des surfaces n'est pas évidente, de sorte que cette solution n'est pas compatible avec des conditions de contact sévères, ainsi que dans le cas de pièces frottantes fortement chargées, c'est-à-dire dont les pressions de contact amènent au fonctionnement en régime dit élastohydrodynamique. En effet, cette texturation, qui revient à effectuer une gravure de motifs sur la surface en contact, entraîne une diminution significative de la surface portante, de sorte qu'une texturation non appropriée conduit immanquablement à une chute de pression du film d'huile et à un endommagement des surfaces, ce qui va à l'encontre du but recherché.

Il en résulte que le principe de la texturation de surface n'est appliqué par l'homme du métier que dans le cas de pièces frottantes faiblement chargées en milieu lubrifié.

A partir de l'analyse de cet état de la technique, l'un des problèmes que se propose de résoudre l'invention est de pouvoir appliquer le principe de la texturation d'une surface frottante afin de prolonger l'existence d'un régime de lubrification élastohydrodynamique entre pièces frottantes en milieu lubrifié et fortement chargées, c'est-à-dire travaillant sous des pressions de contact, par exemple, supérieures à 200 MPa.

En effet, au-delà d'un certain seuil de pression de contact, l'augmentation exponentielle de la viscosité du lubrifiant (plusieurs ordres de grandeur) change radicalement son comportement physique. Le lubrifiant change alors d'état, pour se comporter de façon plus proche de celle d'un solide que d'un fluide. La séparation complète des surfaces de contact est alors permise par la déformation élastique des surfaces antagonistes, sous l'action du lubrifiant devenu extrêmement visqueux. On se situe alors dans le régime dit élastohydrodynamique. Le comportement physique du lubrifiant et des surfaces antagonistes étant fondamentalement différent en régime élastohydrodynamique, on comprendra ainsi que l'optimisation d'une texturation de surface pour le contact s'effectue très différemment que pour le cas des autres interfaces lubrifiées.

L'originalité de la présente invention consiste ainsi en l'optimisation réussie, en terme de frottement et d'usure, d'une texturation de surface pour les contacts fonctionnant au moins partiellement en régime élastohydrodynamique, à des pressions de contact supérieures à 200 MPa et dont la surface est texturée et soumise, avant ou après texturation, à un traitement de durcissement superficiel à fonction tribologique.

Conformément à l'invention, la pièce de frottement présente les caractéristiques de la revendication 1.

Pour résoudre le problème posé d'obtenir une surface texturée selon les caractéristiques de l'invention, le réseau périodique des cavités est obtenu notamment par un procédé d'usinage par impulsions laser femtoseconde ou bien par faisceau d'ions, ou bien par micro-usinage, ou bien par déformation plastique, ou bien par attaque chimique, ou bien par électroérosion.

Avantageusement, la pièce de frottement dont la surface est texturée, est soumise, avant ou après texturation, à un traitement de durcissement superficiel à fonction tribologique. Ce traitement est avantageusement obtenu par dépôt d'une couche mince de carbone amorphe (DLC), afin de limiter l'endommagement des surfaces et abaisser le coefficient de frottement avant le passage en lubrification élastohydrodynamique des pièces frottantes fortement chargées.

Comme indiqué, la texturation de surface frottante peut être obtenue selon différents procédés. Les impulsions par laser femtoseconde permettent un enlèvement de matière par sublimation sans modification significative de la microstructure. A noter cependant que les techniques de micro-usinage (lithographie, microérosion) ou de déformation plastique de surface (moletage, micropercussion) ou électrochimiques (attaques chimiques, électroérosion) permettent d'obtenir des résultats similaires. Les motifs périodiques réalisés sur les surfaces texturées constituent des cavités qui peuvent être définies selon les quatre paramètres essentiels suivants :
- la forme dans le plan de la surface (circulaire, elliptique, carré, triangulaire, rainure, etc...) ;
- le profil dans l'épaisseur de la matière (cylindre, demi-sphère, cône, etc...) ;
- les dimensions (diamètre, largeur, profondeur, etc...) ;
- la période considérée dans toutes les directions, et par rapport à la direction de frottement de surface.

La profondeur des cavités est, conformément à l'invention, inférieure ou égale à 3 µm afin de limiter l'endommagement des couches minces et de maximiser leur influence sur le régime de lubrification, avec un résultat optimum constaté par des motifs autour de 500 nm plus ou moins 250 nm de profondeur. On rappelle que les pièces texturées selon l'invention peuvent être traitées avant ou après texturation par des traitements thermochimiques traditionnels (cémentation, carbonitruration, et autres traitements de diffusion ou de conversion) ou des dépôts sous vide obtenus par les procédés PVD (Physical Vapour Déposition) ou PACVD (Plasma Assisted Chemical Vapour Deposition), tels que des nitrures ou des carbures de métaux de transition ou des dépôts de carbone amorphe (DLC).

Les différentes dimensions et orientations des motifs sont adaptées aux pièces à traiter, selon les dimensions des surfaces de contact, le sens et la vitesse de glissement, les pressions de contact et la courbure des pièces traitées. Par exemple, sur des pièces mécaniques soumises à des pressions de contact très élevées, telles que des pièces de culbuterie dans le domaine de l'automobile, il est nécessaire de réaliser des profondeurs de motifs faibles d'environ 500 nm.

A noter que l'apport d'une couche dure, comme indiqué précédemment, par rapport à une surface texturée non revêtue, permet entre autre de réduire, d'une manière significative, l'endommagement des motifs au cours du temps et, par conséquent, de maintenir les performances tribologiques des surfaces texturées. On observe également qu'outre une influence sur le régime de lubrification, la texturation permet également de bloquer, de manière surprenante, la propagation de fissures issues d'un décollement localisé du dépôt.

L'invention est exposée ci-après plus en détail à l'aide des figures annexées dans lesquels ;
- la figure 1 est un graphique montrant l'évolution du gain apporté par les motifs de la surface texturée ;
- la figure 2 montre un exemple d'une surface texturée par un réseau de trous ;
- la figure 3 montre les mesures de frottement obtenues lorsque la pression maximale de contact est maintenue constante à 2,4 CPa :
- la figure 4 représente trois courbes de frottement montrant l'influence d'une micro-texturation sur le niveau de frottement.

On renvoie à l'exemple n° 1 de traitement ci-après :

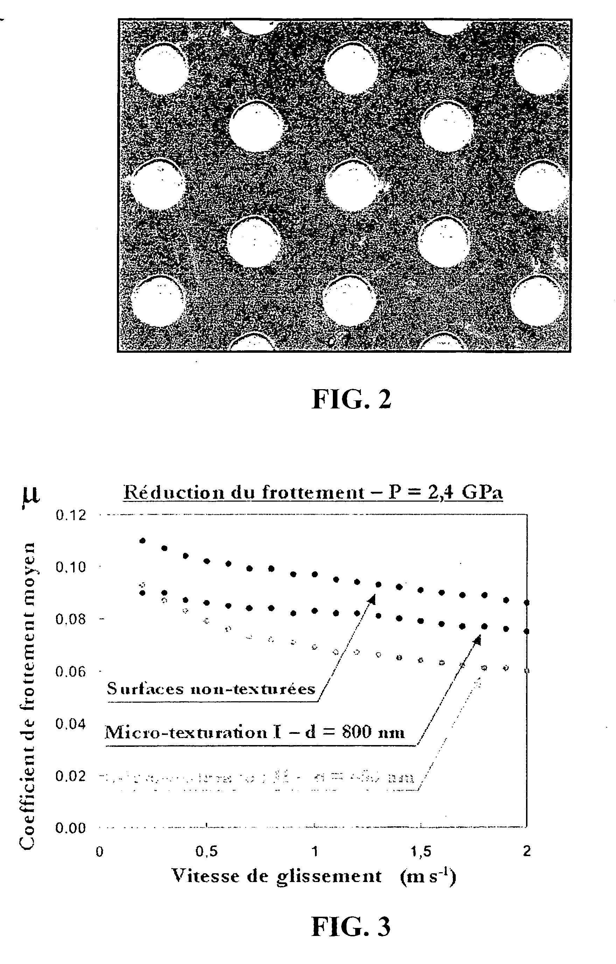

Les pièces traitées sont des galets à portée sphérique de 50 mm de diamètre, en acier X85WCrMoV6-5-4-2 tribofinis. Ces pièces ont été revêtues d'un dépôt de DLC de 2 µm d'épaisseur, dans lequel des trous (micro-cavités de forme circulaire) ont été effectués par des impulsions laser femtoseconde. Les surfaces sont texturées par un réseau de trous de 79 µm de diamètre et de 400 nm de profondeur, espacés de 125 µm, tel que représenté en figure n°2, Le réseau est constitué d'une succession de rangées de 7 et de 8 trous décalées, sur une bande de largeur 1 mm disposée au centre de la piste de frottement du galet.

Ces galets sont utilisés pour des essais de frottement sur une machine dite « Amsler » (essai tribologique de référence pour l'homme de l'art), sous des pressions de contact élevées (de 1 à 3,2 GPa de pression maximale de contact), des vitesses de glissement allant de 0,2 à 2 m/s, et de faibles vitesses d'entraînement du lubrifiant dans le contact (10 % de la vitesse de glissement). Chaque pièce texturée a été testée face à un galet non revêtu et non texturé, afin d'observer l'influence de la texturation sur le coefficient de frottement en régime lubrifié (huile moteur 10W40), et pour étudier la tenue en service des revêtements sous différentes pressions de contact. Un galet revêtu de DLC mais non texturé a également été testé face à un galet non revêtu et non texturé, pour servir de référence, et isoler précisément l'effet des texturations testées sur les performances du contact.

Afin de quantifier le gain apporté par la microtexturation, des essais de frottement ont été réalisés en diminuant progressivement la vitesse de glissement de manière à rompre le film d'huile, à charge appliquée constante.

La réalisation d'essais sur des surfaces lisses revêtues, conduisant déjà à un gain sur le coefficient de frottement par rapport aux mêmes surfaces mais sans dépôt de DLC, les surfaces revêtues de DLC avec ce motif sous une pression de contact de 2 GPa ont révélé un gain significatif sur le coefficient de frottement.

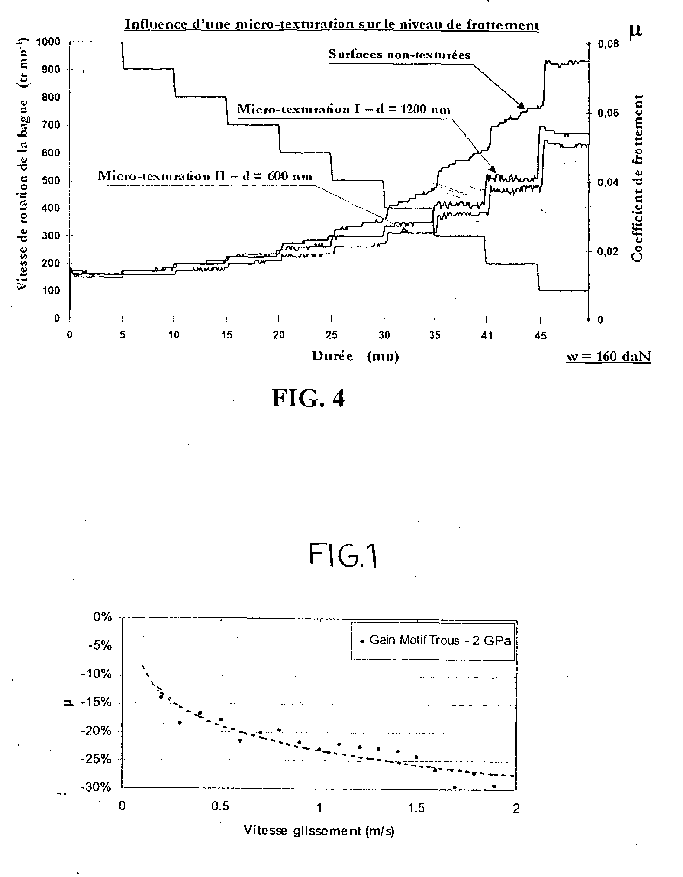

Le graphique en figure n° 1 en annexe présente l'évolution du gain apporté par ce motif particulier sur le coefficient de frottement (en comparaison avec le même essai réalisé sans texturation), en fonction de la vitesse de glissement des antagonistes dans un bain d'huile. On remarque que sous cette pression de contact de 2 GPa, le coefficient de frottement peut être réduit de 30 % par ce motif par rapport à une surface revêtue non texturée. A titre de remarque, la réalisation d'un dépôt de DLC non texturé permet déjà de réduire le coefficient de frottement de 15 % par rapport à une surface en acier poli non traité.

Dans cette configuration précise, l'application d'un dépôt texturé conduit à une réduction de la puissance dissipée par le frottement de 30 W et permet également de réduire l'échauffement des surfaces et de l'huile, ce qui est favorable à la durabilité des composants.

### Exemple de traitement n° 2,:

En suivant strictement la même procédure que pour l'exemple de traitement n°1, que ce soit pour le revêtement et la texturation de la piste de frottement des galets de test, comme pour la réalisation des essais sur machine Amsler, une seconde série d'essais de frottement a été réalisée à différentes pressions de contact.

La figure n°3 présente les mesures de frottement obtenues, lorsque la pression maximale de contact est maintenue constante à 2,4 GPa, et pour différentes vitesses de glissement imposées.

Un premier galet à portée sphérique à été revêtu de DLC, puis texturé en suivant le réseau de micro-cavités circulaires tel que décrit dans l'exemple de traitement n°1. La profondeur des micro-cavités a été portée à 5 µm, cette valeur étant un exemple représentant ce qui est couramment utilisé par l'homme de l'art (non couvert par la présente invention). Après démarrage de l'essai avec application de l'effort normal imposé au contact, la destruction des surfaces antagonistes par délamination du dépôt de DLC et grippage des surfaces est intervenue après seulement 25 secondes. La texturation de surface comme elle est pratiquée usuellement n'est donc pas adaptée à ce contact élastohydrodynamique.

Les trois autres essais réalisés ensuite à cette pression de contact de 2,4 GPa sont présentés en figure n°3. Les courbes de frottement obtenues montrent ainsi clairement que l'optimisation des dimensions, et en particulier de la profondeur « d » des micro-cavités pour des valeurs fixées avantageusement à 800 nm, et encore plus avantageusement à 450 nm, permet d'obtenir une importante réduction du frottement généré au sein du contact.

Il s'agit en effet de dimensionner la profondeur des micro-cavités en fonction de l'épaisseur du film d'huile séparant les surfaces de contact, calculée par les formules analytiques classiques de la théorie de la lubrification élastohydrodynamique. Cette profondeur est avantageusement comprise entre 0,1 et 10 fois l'épaisseur de film de lubrifiant calculée théoriquement.

De manière inattendue, la figure n°3 montre ainsi clairement que le choix de la profondeur des cavités fixée à 450 nm permet une réduction systématique de l'énergie dissipée par frottement, allant 15 % à 35 %, comparativement à la même surface sans micro-texturation.

Les essais comparatifs entre le galet à surface revêtue de DLC non texturée, et le galet à surface revêtue de DLC présentant la texturation de profondeur 450 nm sont ensuite poursuivis, en fixant la pression maximale de contact à des valeurs plus élevées, soit 2,6 GPa, 2,8 GPa, 3 GPa, et 3,2 GPa.

Lors du premier essai à pression maintenue constante à 2,6 GPa, la surface revêtue et non texturée du galet de référence est détruite immédiatement, par délamination du dépôt de DLC puis grippage des surfaces antagonistes. La valeur de 2,6 GPa est ainsi retenue comme la limite de pression de contact maximale supportée par la surface de référence sans texturation.

Comparativement, l'essai réalisé dans les mêmes conditions strictement est mené à son terme sans endommagement, avec la surface revêtue et présentant la texturation de profondeur 450 nm.

De même, cet essai est ensuite reproduit trois fois en utilisant ce galet texturé à 450 nm de profondeur, et en augmentant encore la pression de contact maintenue constante à 2,8 GPa la première fois, 3,0 GPa la seconde fois, et 3,2 GPa la troisième fois.

De manière inattendue, la surface frottante de ce galet présentant la texturation la plus avantageuse n'est pas endommagée à la fin de cette série d'essais, et on conclue ainsi que la texturation optimisée en suivant notre invention permet d'augmenter considérablement la capacité d'une surface à supporter la pression de contact qui lui est appliquée.

Etonnamment, en plus de réduire l'énergie dissipée par frottement, l'invention permet ainsi de conférer à la surface une meilleure résistance à la charge, et augmente ainsi sensiblement sa durée de vie.

### Exemple de traitement n° 3 :

Les pièces traitées sont des plaquettes rectangulaires et planes de dimensions 30 mm x 18 mm, de 8 mm d'épaisseur, en acier X85WCrMoV6-5-4-2. Ces pièces sont revêtues d'un dépôt de DLC de 2 µm d'épaisseur, dans lequel des trous (micro-cavités de forme circulaire) ont été effectués par des impulsions laser femtoseconde. Les surfaces sont texturées par un réseau de trous de 79 µm de diamètre, espacés de 125 µm, tel que représenté en figure n°2. Le réseau est constitué d'une succession de rangées trous décalées, couvrant la totalité de la surface frottante. Deux plaquettes sont texturées selon cette description, l'une avec des micro-cavités de profondeur 1200 nm, l'autre avec des micro-cavités de profondeur 600 nm. Une troisième plaquette de référence est revêtue du même dépôt de DLC strictement, mais n'est pas texturée. L'influence des deux texturations de surface réalisées sur les performances du contact peut ainsi être isolée par comparaison avec la plaquette revêtue et lisse.

Ces plaquettes sont ensuite utilisées pour des essais de frottement sur une machine dite « cylindre/plan ». Ce dispositif permet de mettre en contact un cylindre en acier X85WCrMoV6-5-4-2 présentant une piste extérieure de frottement de diamètre 35 mm, et de largeur 8 mm, avec une plaquette telle que définie au paragraphe précédent. Le cylindre est entraîné en rotation autour de son axe propre. La plaquette est maintenue sur un montage lui imprimant un mouvement de va-et-vient horizontal, selon la direction de sa plus grande dimension. La ligne du contact établit entre la surface extérieure du cylindre et la surface de la plaquette effectue ainsi des allers-retours sur la surface plane traitée. Un vérin pneumatique permet d'appliquer un effort normal sur le montage supportant la plaquette, et ainsi de générer une importante pression de contact entre la plaquette et le cylindre en mouvement. Les deux solides en contact sont enfermés dans un bac rempli d'huile moteur 10W40, chauffée, et régulée en température.

Les essais décrits sont réalisés successivement pour différents efforts constants appliqués au contact, soit 40 daN, 80 daN, 120 daN, puis 160 daN, en faisant descendre par paliers successifs la vitesse de rotation du cylindre de 1000 tr/min à 100 tr/min (donnant une vitesse de glissement comprise respectivement entre 2 m/s et 0,2 m/s). Cette descente en vitesse permet ainsi de réduire l'épaisseur du film d'huile séparant les surfaces antagonistes, et de provoquer la transition entre le régime de lubrification élastohydrodynamique, et le régime mixte.

Pour la charge normale testée et maintenue constante à 160 daN (induisant une pression maximale au contact de 700 MPa), les mesures de frottement obtenues sont reportées en figure n°4.

De façon inattendue, par comparaison des trois courbes de frottement de la figure n°4, on constate que la texturation optimisée selon notre invention, et avantageusement de profondeur « d » égale à 600 nm permet ici de réduire systématiquement le coefficient de frottement mesuré. Cette réduction de l'énergie dissipée par frottement atteint ici jusqu'à 30 %, lorsque les conditions de lubrification sont les plus sévères.

L'application de la texturation de surface dans le cadre de l'invention présentée ici permet de décaler la transition entre régime élastohydrodynamique et régime mixte vers des conditions de fonctionnement plus sévères.

Cette diminution du frottement est de nouveau obtenue en adaptant les dimensions, et en particulier la profondeur des micro-cavités « d », qui doit être avantageusement comprise entre 0,1 et 10 fois l'épaisseur du film lubrifiant.

Les avantages de l'invention illustrée par ces trois exemples ressortent bien de la description faite, et en particulier, on souligne et on rappelle :
- réduire significativement le coefficient de frottement dans des conditions de fonctionnement bien définies en favorisant le passage en régime de lubrification élastohydrodynamique ;
- augmenter la pression de contact maximale admissible par la surface traitée, avant sa destruction ;
- limiter l'endommagement du dépôt par un confinement des écailles entre deux périodes du motif réalisé, et par une évacuation des particules d'usure dans les cavités ;
- augmenter la durabilité des pièces mécaniques, en limitant leur usure.

L'invention trouve une application particulièrement avantageuse dans le cadre d'une lubrification en régime élastohydrodynamique de pièces frottantes fortement chargées (pressions de contact supérieures à 0,2 MPa, supérieures à 0,5 MPa, supérieures à 0,8 MPa), notamment dans le domaine de l'automobile et plus particulièrement pour la réalisation de composants de moteurs, notamment de culbuterie tels que linguets ou poussoirs dans le domaine des véhicules de loisirs ou de compétition.

L'invention trouve également une application avantageuse dans le cadre de la lubrification en régime élastohydrodynamique de pièces frottantes fortement chargées de transmission de puissance, notamment pour le traitement de dentures d'engrenages, intervenant notamment dans les boites de vitesses pour véhicules de loisirs ou de compétition.

## Revendications

1. Pièce de frottement en milieu lubrifié travaillant à des pressions de contact supérieures à 200 MPa et dont la surface est texturée et soumise, avant ou après texturation, à un traitement de durcissement superficiel à fonction tribologique,
**caractérisée en ce que** ladite surface présente un réseau périodique de cavités micrométriques dont la grande longueur est comprise entre 5 et 500 µm et dont la période est inférieure à la moitié de la largeur de contact, et la profondeur desdites cavités étant inférieure ou égale à 3 µm, afin de favoriser le passage en régime de lubrification élastohydrodynamique.

2. Pièce selon la revendication 1, **caractérisée en ce que** les cavités micrométriques sont constituées par des trous et/ou des rainures.

3. Pièce selon la revendication 1, **caractérisée en ce que** la profondeur des cavités est inférieure ou égale à 1 µm.

4. Pièce selon la revendication 1, **caractérisée en ce que** le réseau périodique des cavités est obtenu par un procédé d'usinage par impulsions laser femtoseconde.

5. Pièce selon la revendication 1, **caractérisée en ce que** le réseau périodique des cavités est obtenu par micro-usinage.

6. Pièce selon la revendication 1, **caractérisée en ce que** le réseau périodique des cavités est obtenu par déformation plastique des surfaces.

7. Pièce selon la revendication 1, **caractérisée en ce que** le réseau périodique de cavités est obtenu par attaque chimique ou électroérosion.

8. Pièce selon la revendication 1, **caractérisée en ce que** le réseau périodique de cavités est obtenu par procédé d'usinage par faisceau d'ions.

9. Pièce selon la revendication 1, **caractérisée en ce que** le traitement de durcissement superficiel est obtenu par dépôt d'une couche mince de carbone amorphe (DLC).

10. Utilisation des pièces selon l'une quelconque des revendications 1 à 9 dans le domaine de l'automobile et notamment des moteurs et des boites de vitesse.

11. Utilisation selon la revendication 104 pour la réalisation de traitements sur composants de culbuterie notamment de type linguets ou de type poussoirs.

12. Utilisation selon la revendication 104 pour la réalisation de traitement sur composants de transmission de puissance, notamment de type dentures d'engrenages.

13. Utilisation selon les revendications 1 à 12, sur pièces soumises durant tout ou partie de leur fonctionnement à des pressions maximales de contact supérieures à 0,5 GPa, en utilisant avantageusement des micro-cavités à la profondeur inférieure à 1 µm.

14. Utilisation selon les revendications 1 à 12, sur pièces soumises durant tout ou partie de leur fonctionnement à des pressions maximales de contact supérieures à 0,8 GPa, en utilisant avantageusement des micro-cavités à la profondeur inférieure à 1 µm.

15. Utilisation selon les revendications 1 à 14, en fixant la profondeur des micro-cavités entre 0,1 et 10 fois l'épaisseur du film de lubrifiant séparant les surfaces de contact.

## Claims

1. Friction part in a lubricated medium working at contact pressures higher than 200 MPa and having a surface that is textured and subjected, before or after texturizing, to a case hardening treatment for a tribological function,
**characterized in that** said surface has a periodic network of micrometric cavities having a long length between 5 and 500 µm and a period that is less than half the contact width, and the depth of said cavities being less than or equal to 3 µm, in order to facilitate the transition to an elastohydrodynamic lubrication regime.

2. Part as claimed in claim 1, **characterized in that** the micrometric cavities comprise holes and/or grooves.

3. Part as claimed in claim 1, **characterized in that** the depth of the cavities is less than or equal to 1 µm.

4. Part as claimed in claim 1, **characterized in that** the periodic network of the cavities is obtained by a femtosecond laser pulse machining method.

5. Part as claimed in claim 1, **characterized in that** the periodic network of the cavities is obtained by micro-machining.

6. Part as claimed in claim 1, **characterized in that** the periodic network of the cavities is obtained by plastic deformation of the surfaces.

7. Part as claimed in claim 1, **characterized in that** the periodic network of the cavities is obtained by chemical attack or electroerosion.

8. Part as claimed in claim 1, **characterized in that** the periodic network of the cavities is obtained by an ion beam machining method.

9. Part as claimed in claim 1, **characterized in that** the case hardening treatment is obtained by deposition of a thin layer of amorphous carbon (DLC).

10. Use of the parts as claimed in any one claims 1 to 9 in the automobile field and particularly for engines and gearboxes.

11. Use as claimed in claim 10 for carrying out treatments on rocker arm components such as pawls or push rods.

12. Use as claimed in claim 10 for carrying out treatments on power transmission components, such as gear teeth in particular.

13. Use as claimed in claims 1 to 12, on parts subjected during all or part of their operation to maximum contact pressures above 0.5 GPa, by using to advantage micro-cavities having a depth of less than 1 µm.

14. Use as claimed in claims 1 to 12, on parts subjected during all or part of their operation to maximum contact pressures above 0.8 GPa, by using to advantage micro-cavities having a depth of less than 1 µm.

15. Use as claimed in claims 1 to 14, setting the micro-cavity depth at between 0.1 and 10 times the thickness of the lubricant film separating the contact surfaces.

## Patentansprüche

1. Reibungsteil in einer geschmierten Umgebung, das bei Kontaktdrücken von über 200 MPa arbeitet und dessen Oberfläche texturiert ist und das vor oder nach der Texturierung einer Oberflächenhärtebehandlung mit tribologischer Funktion unterzogen wird,
dadurch gekennzeichet, dass die besagte Oberfläche ein periodisches Netz von mikrometrischen Hohlräumen aufweist, deren größere Länge zwischen 5 und 500 µm beträgt und dessen Periode geringer ist als die Hälfte der Kontaktbreite, wobei die besagten Hohlräume weniger als oder gleich 3 µm tief sind, um den Übergang in ein elastohydrodynamisches Schmiersystem zu begünstigen.

2. Teil nach Anspruch 1, **dadurch gekennzeichnet, dass** die mikrometrischen Hohlräume aus Löchern und/oder Rillen bestehen.

3. Teil nach Anspruch 1, **dadurch gekennzeichnet, dass** die Hohlräume weniger als oder gleich 1 µm tief sind.

4. Teil nach Anspruch 1, **dadurch gekennzeichnet, dass** das periodische Netz der Vertiefungen durch ein Bearbeitungsverfahren mit Femtosekundenlaserimpulsen erzielt wird.

5. Teil nach Anspruch 1, **dadurch gekennzeichnet, dass** das periodische Netz der Vertiefungen durch Mikrobearbeitung erzielt wird.

6. Teil nach Anspruch 1, **dadurch gekennzeichnet, dass** das periodische Netz der Vertiefungen durch plastische Oberflächenverformung erzielt wird.

7. Teil nach Anspruch 1, **dadurch gekennzeichnet, dass** das periodische Netz der Vertiefungen durch chemischen Angriff oder Elektroerosion erzielt wird.

8. Teil nach Anspruch 1, **dadurch gekennzeichnet, dass** das periodische Netz der Vertiefungen durch ein Bearbeitungsverfahren per Ionenstrahl erzielt wird.

9. Teil nach Anspruch 1, **dadurch gekennzeichnet, dass** die Oberflächenhärtebehandlung durch Auftrag einer dünnen Schicht aus amorphem Kohlenstoff (DLC) erzielt wird.

10. Verwendung der Teile nach einem der Ansprüche 1 - 9 im Automobilbau, insbesondere für Motoren und Getriebe.

11. Verwendung der Teile nach Anspruch 10 für die Durchführung von Behandlungen auf Kipphebelkomponenten, insbesondere Unterbrecherhebel oder Stößel.

12. Verwendung der Teile nach Anspruch 10 für die Durchführung von Behandlungen auf Leistungsübertragungskomponenten, insbesondere Getriebeverzahnungen.

13. Verwendung nach den Ansprüchen 1 - 12 auf Teilen, die während ihres ganzen Betriebs oder Teil ihres Betriebs maximalen Kontaktdrücken über 0,5 GPa ausgesetzt sind, wobei vorteilhafterweise Mikrohohlräume mit einer Tiefe unter 1 µm verwendet werden.

14. Verwendung nach den Ansprüchen 1 - 12 auf Teilen, die während ihres ganzen Betriebs oder Teil ihres Betriebs maximalen Kontaktdrücken über 0,8 GPa ausgesetzt sind, wobei vorteilhafterweise Mikrohohlräume mit einer Tiefe unter 1 µm verwendet werden.

15. Verwendung nach den Ansprüchen 1 - 14, wobei die Tiefe der Mikrohohlräume so festgelegt wird, dass sie 0,1 - 10mal der Dicke des die Kontaktflächen trennenden Schmierfilms entspricht.
